# EUROPÄISCHE PATENTSCHRIFT

(11) **EP 0 487 784 B1**
(45) Veröffentlichungstag und Bekanntmachung des Hinweises auf die Patenterteilung: **15.03.1995**
(21) Anmeldenummer: 90123009.4
(22) Anmeldetag: 30.11.1990
(51) Int. Cl.: G01R 31/36

(54) **Verfahren zum Erkennen eines Ladungsgrenzwertes einer Batterie**
Method for detecting the charge limit of a battery
Procédé de détection de la limite de charge d'une batterie

(43) Veröffentlichungstag der Anmeldung: 03.06.1992
(73) Patentinhaber: SIEMENS AKTIENGESELLSCHAFT, 80333 München (DE)
(72) Erfinder: Glehr, Manfred, Dipl.-Ing., W-8330 Eppenfelden (DE)

(56) Entgegenhaltungen:
- EP-A- 0 339 407
- WO-A-90/04188
- US-A- 4 950 913

## Beschreibung

Die Erfindung betrifft ein Verfahren gemäß dem Oberbegriff von Patenanspruch 1, das für sich durch EP-A-0 339 407 vorbekannt ist. Schon dieses bekannte Verfahren gestattet, daß der momentane Ladungszustand der Batterie ein Starten des Motors möglichst in jedem Falle gewährleistet ist. Die Erfindung ermöglicht aber vor allem eine vergleichsweise verbesserte Berechnung des momentanen Batterieladungszustandes.

Andere bekannte Verfahren verwenden einen sogenannten Shunt, einen niederohmigen Widerstand, dessen Spannungsabfall einen Rückschluß auf den durch den Shunt fließenden Strom erlaubt. Die Verwendung eines Shunt ist aber auf einen engen Strombereich begrenzt. Sollen hohe Ströme erfaßt werden, muß der Shunt sehr niederohmig sein, bei niedrigen Strömen erhält man dann aber keinen ausreichend großen Spannungsabfall am Shunt. Möchte man geringe Ströme messen, so ist ein relativ hochohmiger Shunt einzusetzen, der aber bei hohen Strömen einen nachteilig hohen Spannungsabfall zur Folge hat.

Die Erfindung soll daher die Aufgabe lösen,
- die Überwachung des Ladungszustandes der Batterie, insbesondere mittels einer geschickt gewählten Berechnungsmethode zu ermöglichen, damit der Ladungszustand der Batterie möglichst einen bestimmten Grenzwert nich unterschreitet, wobei sowohl hohe Ströme, z.B. beim Starten eines Kraftfahrzeuges, als auch kleine Ströme etwa der Verbrauch einer ständig eingeschalteten Borduhr erfasst werden.
Die Erfindung löst diese Aufgabe durch das in Anspruch 1 angegebene Verfahren.

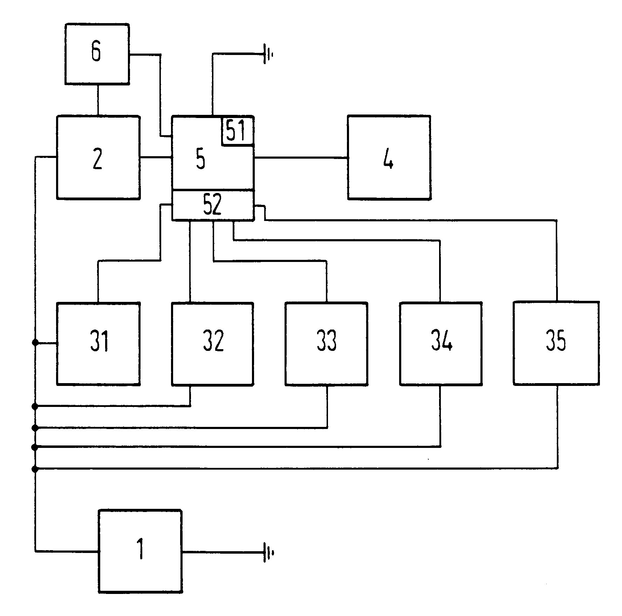

Die Erfindung wird anhand des in der Figur gezeigten Schemas eines Ausführungsbeispieles näher erläutert.

Die Batterie 1 ist über das Bordnetz eines Fahrzeuges mit dem Generator 2 und mehreren individuell zuschaltbaren Verbrauchern 31, 32, 33, 34, 35 verbunden, welche jeweils eine unterschiedliche Leistungsaufnahme haben. Es kann sich dabei um Verbraucher mit einer vergleichsweise sehr hohen Leistungsaufnahme, z.B. dem Anlaßer, oder auch einem Verbraucher mit einer sehr geringen Leistungsaufnahme, z.B. der Borduhr, handeln. Ein Steuergerät 5 erkennt, welche Verbraucher gerade an das Bordnetz zugeschaltet sind.

In einem Speicher 51 ist die normierte Leistungsaufnahme der jeweiligen Verbraucher 31, 32, 33, 34, 35 abgelegt. Das Steuergerät 5 ermittelt aus den ihm bekannten, zugeschalteten Verbrauchern 31, 32, 33, 34, 35 und den dazugehörigen normierten Leistungsaufnahmen die momentane Gesamtleistungsaufnahme. Gleichzeitig ermittelt das Steuergerät 5 die momentane Leistungsabgabe des Generators 2.

Bei bekannten Übersetzungsverhältnissen zwischen dem Motor 6 und dem Generator 2 und bekannter Leistungskennlinie des Generators 2 läßt sich die vom Generator abgegebene Leistung anhand der Generatordrehzahl berechnen, wobei sich die Generatordrehzahl aus der Motordrehzahl und dem Übersetzungsverhältnis von Motordrehzahl zu Generatordrehzahl ergibt.

Einerseits aus der momentanen Gesamtleistungsaufnahme aller momentan zugeschalteten Verbraucher und andererseits aus der Leistungsabgabe des Generators 2 ermittelt das Steuergerät, ob die Batterie 1 momentan geladen wird, d.h. ob der Generator mehr Leistung abgibt als die Gesamtleistungsaufnahme beträgt oder die Batterie entladen wird, d.h. ob der Generator weniger Leistung abgibt als die Gesamtleistungsaufnahme beträgt. Überschreitet die Gesamtleistungsaufnahme die Leistungsabgabe des Generators, dann findet eine Entladung der Batterie statt.

Das Steuergerät ermittelt nun aus dem Entladestrom und der bekannten Kapazität der Batterie den verbleibenden, momentanen Ladezustand dieser Batterie. Der Ladungsgrenzwert ist so gewählt, daß die verbleibende Ladung der Batterie 1 ein Starten des Motors 6 in jedem Falle gewährleistet.

Beim gezeigten Beispiel aktiviert das Steuergerät 5 eine Warneinheit 4 bei Unterschreiten eines bestimmten Ladungsgrenzwertes. Zusätzlich kann das Steuergerät 5 auch zwangsweise einzelne Verbraucher 31, 32, 33, 34, 35 abschalten, so daß für diese abgeschalteten Verbraucher kein Entladestrom mehr aus der Batterie 1 entnommen wird. Im gezeigten Beispiel ist im Steuergerät 5 die Reihenfolge festgelegt, in der die Verbraucher 31, 32, 33, 34, 35 zwangsweise abgeschaltet werden. Dabei können zuerst diejenigen Verbraucher 31, 32, 33, 34, 35 abgeschaltet werden, die für die Fahrsicherheit von nur untergeordneter Bedeutung sind und nur dem Komfort dienen, z.B. die Sitzheizung des Fahrzeuges.

Um den Verkabelungsaufwand zu verringern, kann im Steuergerät 5 eine Abtasteinrichtung 52 vorhanden sein, welche die einzelnen Verbraucher 31, 32, 33, 34, 35 sequentiell daraufhin untersucht, ob sie an das Bordnetz zugeschaltet sind, also ob der betreffende Verbraucher jeweils ein- oder ausgeschaltet ist.

## Patentansprüche

1. Verfahren zum Erkennen eines Ladungsgrenzwertes einer Batterie (1), die mit einem Generator (2) und über ein Bordnetz mit individuell zuschaltbaren elektrischen Verbrauchern (31, 32, 33, 34, 35) verbunden ist,
wobei
- der Normalwert der Leistungsaufnahme jedes Verbrauchers in einem Speicher (51) gespeichert ist,
- die Gesamtleistungsaufnahme aller momentan zugeschalteten Verbraucher anhand der gespeicherten Normalwerte errechnet wird,
- der Lade- bzw. Entladestrom der Batterie aus der Gesamtleistungsaufnahme und der momentanen Leistungsabgabe des Generators ermittelt wird und daraus und aus einem gespeicherten Wert, der den vorhergehenden Ladezustand der Batterie beschreibt, der momentane Ladezustand der Batterie ermittelt wird,
- bei Unterschreiten des Ladungsgrenzwertes ein Zustandssignal abgegeben wird,
**dadurch gekennzeichnet**, daß
- die Leistungsabgabe des Generators anhand der Generatordrehzahl und die Generatordrehzahl aus der Motordrehzahl und dem Übersetzungsverhältnis von Motordrehzahl zu Generatordrehzahl ermittelt wird.

2. Verfahren nach Anspruch 1,
**dadurch gekennzeichnet**, daß
- durch das Zustandssignal eine Warneinrichtung (4) ausgelöst wird, die vor einem zu niedrigen Batterieladezustand warnt.

3. Verfahren nach Anspruch 1 oder 2,
**dadurch gekennzeichnet**, daß
- durch das Zustandssignal ausgelöst, einzelne Verbraucher zwangsweise vom Bordnetz abgeschaltet werden.

4. Verfahren nach einem der vorhergehenden Ansprüche,
**dadurch gekennzeichnet**, daß
- die Reihenfolge, in der die einzelnen Verbraucher vom Bordnetz abgeschaltet werden, festgelegt ist.

5. Steuergerät (5) zum Durchführen des Verfahrens nach Anspruch 1,
das
- den Ladungszustand der Batterie überwacht, die mit dem Generator und über ein Bordnetz mit individuell zuschaltbaren elektrischen Verbrauchern verbunden ist,
- erkennt, welche Verbraucher momentan zugeschaltet sind,
- den Speicher aufweist, in dem der bisherige Ladungszustand der Batterie und der Normalwert der Leistungsaufnahme jedes Verbrauchers abgespeichert ist,
- die Gesamtleistungsaufnahme aller momentan zugeschalteten Verbraucher anhand der gespeicherten Werte errechnet,
- den Lade- bzw. Entladestrom der Batterie aus der Gesamtleistungsaufnahme und der momentanen Leistungsabgabe des Generators ermittelt und daraus und aus dem gespeicherten Wert, der den vorhergehenden Ladezustand der Batterie beschreibt, der momentane Ladezustand der Batterie ermittelt,
- bei Unterschreiten des Ladungsgrenzwertes das Zustandssignal abgibt,
- dadurch gekennzeichnet, daß es die Leistungsabgabe des Generators anhand der Generatordrehzahl und die Generatordrehzahl aus der Motordrehzahl und dem Übersetzungsverhältnis von Motordrehzahl (n) zu Generatordrehzahl ermittelt.

6. Steuergerät nach Anspruch 5,
**dadurch gekennzeichnet**, daß
- es eine Abtasteinrichtung (52) enthält, die alle im Bordnetz vorhandenen Verbraucher daraufhin untersucht, ob sie jeweils ein- oder ausgeschaltet sind.

## Claims

1. Method for detecting a charging limit value of a. battery (1) which is connected to a generator (2) and via a vehicle electric system to electrical loads (31, 32, 33, 34, 35) which can be connected up individually,
- the normal value of the power consumption of each load being stored in a store (51),
- the overall power consumption of all loads, which are instantaneously connected up, being calculated with reference to the stored normal values,
- the charging current or discharging current of the battery being determined from the overall power consumption and the instantaneous power output of the generator and the instantaneous charge state of the battery being determined therefrom and from a stored value which describes the preceding charge state of the battery,
- a state signal being emitted in the case of a drop below the charging limit value,
characterized in that
- the power output of the generator is determined with reference to the generator speed and the generator speed is determined from the engine speed and from the transmission ratio of engine speed to generator speed.

2. Method according to Claim 1, characterized in that
- a warning device (4) is triggered by the state signal, which device issues a warning of too low a battery charge state.

3. Method according to Claim 1 or 2, characterized in that
- individual loads are disconnected compulsorily from the vehicle electric system, triggered by the state signal.

4. Method according to one of the preceding claims, characterized in that
- the sequence in which the individual loads are disconnected from the vehicle electric system is specified.

5. Control device (5) for carrying out the method according to Claim 1, which
- monitors the charge state of the battery which is connected to the generator and via a vehicle electric system to electrical loads which can be connected up individually,
- detects which load is connected up instantaneously,
- has the store in which the previous charge state of the battery and the normal value of the power consumption of each load are stored,
- calculates the overall power consumption of all loads, which are instantaneously connected up, with reference to the stored values,
- determines the charging current or discharging current of the battery from the overall power consumption and from the instantaneous power output of the generator and determines the instantaneous charge state of the battery therefrom and from the stored value which describes the preceding charge state of the battery,
- emits the state signal in the case of a drop below the charging limit value,
characterized in that
- it determines the power output of the generator with reference to the generator speed and the generator speed from the engine speed and from the transmission ratio of motor speed (n) to generator speed.

6. Control device according to Claim 5, characterized in that
- it contains a scanning device (52) which examines all loads present in the vehicle electric system as to whether they are switched on or off in each case.

## Revendications

1. Procédé pour détecter une valeur limite de la charge d'une batterie (1), qui est reliée à un générateur (2) et, par l'intermédiaire d'un réseau de bord, à des appareils d'utilisation électriques (31,32,33,34,35), pouvant être branchés individuellement, et selon lequel
- la valeur normale de l'absorption de puissance de chaque appareil d'utilisation est mémorisée dans une mémoire (51),
- l'absorption globale de la puissance de tous les appareils d'utilisation branchés instantanément est calculée sur la base des valeurs normales mémorisées,
- le courant de charge ou de décharge de la batterie est déterminé à partir de l'absorption de la puissance totale et de la délivrance de puissance instantanée du générateur, et l'état de charge instantané de la batterie est déterminé à partir de cela et d'une valeur mémorisée qui décrit l'état de charge précédent de la batterie,
- un signal d'état est délivré dans le cas d'un dépassement de la valeur limite de la charge par valeurs inférieures,
caractérisé par le fait que
- la puissance délivrée par le générateur est déterminée en fonction de la vitesse de rotation du générateur et la vitesse de rotation du générateur est déterminée à partir de la vitesse de rotation du moteur et du rapport de démultiplication entre la vitesse de rotation du moteur et la vitesse de rotation du générateur.

2. Procédé suivant la revendication 1, caractérisé par le fait que
- le signal d'état déclenche un dispositif d'avertissement (4), qui avertit de l'existence d'un état de charge trop faible de la batterie.

3. Procédé suivant la revendication 1 ou 2, caractérisé par le fait que
- des appareils d'utilisation individuels sont débranchés impérativement du réseau de bord, d'une manière déclenchée par le signal d'état.

4. Procédé suivant l'une des revendications précédentes, caractérisé par le fait que
- la séquence, avec laquelle les différents appareils d'utilisation sont déconnectés du réseau de bord, est fixée.

5. Appareil de commande (5) pour la mise en oeuvre du procédé suivant la revendication 1, qui
- contrôle l'état de charge de la batterie, qui est reliée au générateur et, par l'intermédiaire d'un réseau de bord, à des appareils d'utilisation électriques, pouvant être branchés individuellement,
- identifie quels appareils d'utilisation sont instantanément connectés,
- possède la mémoire, dans laquelle l'état de la charge précédent de la batterie et la valeur normale de la consommation de puissance de chaque appareil d'utilisation sont mémorisés,
- l'absorption totale de puissance de tous les appareils d'utilisation instantanément connectés est calculée sur la base des valeurs mémorisées,
- détermine le courant de charge ou de décharge de la batterie à partir de l'absorption de puissance globale et de la puissance instantanée délivrée par le générateur et détermine, à partir de là et à partir de la valeur mémorisée, qui décrit l'état de charge précédent de la batterie, l'état de charge instantané de la batterie,
- délivre le signal d'état, dans le cas du dépassement de la valeur limite de charge par valeurs inférieures,
caractérisé par le fait
- qu'il détermine la puissance délivrée par le générateur sur la base de la vitesse de rotation de ce dernier et détermine la vitesse de rotation du générateur à partir de la vitesse de rotation du moteur et du rapport de démultiplication entre la vitesse de rotation (n) du moteur et la vitesse de rotation du générateur.

6. Appareil de commande suivant la revendication 5, caractérisé par le fait que
- il contient un dispositif d'échantillonnage (52), qui examine tous les appareils d'utilisation présents dans le réseau de bord pour déterminer s'ils sont respectivement connectés ou déconnectés.
